# EUROPEAN PATENT APPLICATION

(11) **EP 1 796 151 A1**
(43) Date of publication of application: **13.06.2007**
(21) Application number: 05447278.2
(22) Date of filing: 09.12.2005
(51) Int. Cl.: H01L 21/28, H01L 29/49

(54) **Low work function metal alloy**

(71) Applicant: INTERUNIVERSITAIR MICROELEKTRONICA CENTRUM ( IMEC), 3001 Leuven (BE); NATIONAL UNIVERSITY OF SINGAPORE, 117546 Singapore (SG)
(72) Inventor: Yu, HongYu, 3001 Leuven (BE); JingDe, Chen, 118999 Singapore (SG); Mingfu, Li, 600032 Singapore (SG); Kwong, Dim-Lee, 117685 Singapore (SG); Biesemans, Serge, 3000 Leuven (BE)
(74) Representative: Van Malderen, Joëlle

(57) **Abstract**

The present invention discloses low work function metals for use as gate electrode in nMOS devices. In particular an alloy of Nickel-Ytterbium (NiYb) is used to fully silicide (FUSI) a silicon gate. The resulting Nickel-Ytterbium-Silicon gate electrode has a work function of about 4.22eV.

## Description

### Field of the Invention

The present invention relates to the field of semiconductor devices, in particular to field effect devices comprising a metal gate electrode, more particularly a metal gate electrode formed by silicidation of a semiconductor material and to methods for fabricating such field effect devices.

### Background of the Invention

In order to improve the performance of MOSFET devices the well known polysilicon is being replaced as gate electrode material by metals. Such metal gates do not suffer from the shortcomings of a semiconducting gate electrode such as gate depletion, dopant diffusion or medium range resistance. However, obtaining the desired work function for both nMOS and pMOS devices in view of controlling the threshold voltage, is not as straightforward as in the case of polysilicon gates as the work function of polysilicon can be tuned by doping the polysilicon with a well-defined amount of an appropriate dopant, e.g. Boron for pMOS devices thereby forming a high work function gate electrode and Phosphorus for nMOS devices thereby forming a low work function gate electrode.

Initially midgap metals were introduced to form metal gates. Midgap metals are materials having a Fermi level near the midgap position between the valence and conduction band of the semiconducting substrate on which the MOSFET is formed. An example of such midgap metal is CoSi₂ having a work function of about 4.65eV. This metal gate material is formed by a full silicidation (FUSI) of a polysilicon gate electrode whereby essentially all the polysilicon is converted into a silicide during reaction with Co. Although symmetric threshold voltages for nMOS and pMOS devices can be obtained using such a midgap metal, these threshold voltages are too high compared with the supply voltage at which these nMOS and pMOS are to operate.

In order to obtain the desired, low, threshold voltage for nMOS and pMOS devices a dual metal gate approach is currently being pursued. Here the material of the gate electrode of the nMOS device is a metal having a low work function, ideally about 4 to 4.2eV, while the material of the pMOS gate electrode is another metal having a high work function, ideally about 5 to 5.2eV. Finding an appropriate low-work function metal for use as nMOS gate electrode is of particular importance as such metal reacts rapidly with the oxygen present in the underlying dielectric, e.g. silicon-oxide or high-k dielectrics.

Tuning of the work function of a gate electrode metal by alloying it with other metals, in order to match the work function requirements for a nMOS or pMOS gate electrode is known.

V. Mistra et al discloses in published United States application US 2003/0160227 the alloying of a first metal having a higher work function with a second metal B having a lower work function. Depending on the ratio, the resulting alloy AₓB₁₋ₓ will have a work function ranging from the work function of the first metal A to the work function of the second metal B. The lowest work function obtainable is determined by the work function of the second metal B, which is selected from the group of Mn, Mg, V, Ti, Cr, Y, Zr, Ta, La, Gd, Sm, Pr, Nb, Al, Hf and alloys thereof. Mistra et al. does not teach the formation of a fully silicided gate electrode using such binary alloys.

J. Liu et al discloses in "Dual-Work-Function Metal Gates by Full Silicidation of Poly-Si With Co-Ni Bilayers", IEEE electron device letters 2005, the formation of dual-work-function metal gates fabricated by full silicidation (FUSI) of a Co-Ni bi-layer and a comparison of these alloyed metal gates with single-metal FUSI systems of CoSi₂ and NiSi. The alloy of CoₓNi₁₋ₓ Si allows combining the low work function of NiSi with the thermal stability of CoSi.

Yu et al discloses in "Low Work function Fully Silicided Gate on SiO2/Si and La AlO3/GOI n-MOSFETS", proceedings of 62nd Device Research Conference (DRC), pp. 21, Notre Dame, Indiana, June, 2004, the combination of the low resistive NiSi, having a high work function, of about 4.9eV with Hf or TiSi to obtain a low work function of 4.2eV and 4.3eV respectively.

Aim: low work function material with reproducibility, processing, stability.

### Summary of the Invention

The present invention provides a nMOSFET device comprising a gate electrode and a gate dielectric characterized in that the gate electrode comprises Nickel (Ni), Ytterbium (Yb) and Silicon (Si).

Preferably, in a nMOSFET of the invention, the gate electrode comprises or consists of an alloy of Nickel (Ni), Ytterbium (Yb) and Silicon (Si).

Said alloy can be represented by the formula NiₓYbySi_{1-x-y} where 0.3 < x < 0.7, and 0.005 < y < 0.2. Preferably, x = 0.55 and y = 0.12.

Another object of the present invention is a metallic alloy comprising Nickel (Ni), Ytterbium (Yb) and Silicon (Si).

Said metallic alloy can be represented by the formula NiₓYb_{y}Si_{1-x-y} where 0.3 < x < 0.7, and 0.005 < y < 0.2. Preferably, x = 0.55 and y = 0.12.

Said metallic alloy can be used as a low work function material.

Said metallic alloy can be used as a low work function material in a nMOSFET device, i.e. said work function is smaller than (about) 4,5 eV, preferably said work function is comprised between (about) 3,9 eV and (about) 4,5 eV, more preferably said work function is comprised between (about) 4 eV and (about) 4,2 eV.

The present invention also provides a method for forming an alloy, which can be used as low work function material, comprising the steps of:
- providing at least one layer comprising Nickel, Ytterbium and Silicon, or
- providing at least one layer stack, said stack comprising Nickel, Ytterbium and Silicon, and wherein each layer comprises Nickel, Ytterbium and/or Silicon, and
- annealing said layer(s) to form a Nickel, Ytterbium, Silicon alloy.

The present invention also provides a method for forming a (partially or fully) silicided nMOSFET comprising the steps of:
- depositing Nickel and Ytterbium on at least a semiconductor gate electrode comprising (or consisting of) silicon,
- transforming (partially or fully) (by heat treatment) said semiconductor gate electrode in a Nickel-Ytterbium-Silicide gate electrode.

Preferably, a fully silicided nMOSFET (FUSI nMOSFET) is formed.

In a method of the invention, the step of depositing said Nickel and Ytterbium can consist of depositing alternatively at least one layer of nickel and at least one layer of ytterbium.

Said Nickel and Ytterbium can be sequentially sputtered on said semiconductor gate electrode.

Preferably, the last layer deposited is a nickel layer.

Alternatively, said Nickel and Ytterbium can be co-deposited, in particular they can be simultaneously sputtered on said semiconductor gate electrode.

A capping layer can be deposited over said deposited Nickel and Ytterbium before the step of transforming said semiconductor gate electrode in a Nickel-Ytterbium-Silicide gate electrode.

A method of the invention can further comprise the step of selectively removing the unreacted Nickel and Ytterbium after forming the Nickel-Ytterbium Silicide gate electrode.

### Brief Description of the Drawings

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Figure 1 shows a schematic cross-section of devices according to the present invention (a) bulk MOSFET, (b) MuGFET.

Figure 2 a-g show schematic cross-sections of a device according to the present invention illustrating different steps in the manufacturing process.

Figure 3 shows measured and simulated capacitance C versus gate voltage V_{g} data for a capacitor with FUSI gate according to the present invention.

Figure 4 shows measured (lines) and simulated (symbols) capacitance C versus gate voltage V_{g} data for a capacitor with FUSI gate according to the present invention (solid squares) and for a capacitor with a prior art Nickel-silicide FUSI gate (circles).

Figure 5 shows Equivalent Oxide Thickness (EOT) vs. Flat-band voltage V_{fb} data for capacitors with a FUSI gate electrode according to the present invention.

Figure 6 shows measured (lines) and simulated (symbols) capacitance C versus gate voltage V_{g} data for capacitors with a FUSI gate according to the present invention, whereby the Nickel/Ytterbium ratio in the as-deposited layer was varied from one capacitor to another.

Figure 7 shows measured (lines) and simulated (symbols) capacitance C versus gate voltage V_{g} data for capacitors with a FUSI gate according to the present invention, whereby Nickel and Ytterbium was either co-deposited (circles) or sequentially deposited (diamond).

### Description of the Invention

The present invention provides a low work function metal, its use as gate electrode for nMOS devices, a method for forming nMOS devices comprising such low work function metal, and devices obtained thereof.

The present invention discloses a low work function metallic alloy (5) comprising Nickel, Ytterbium and Silicon.

The present invention also discloses a method to manufacture a metallic alloy having a low work function, the alloy comprising Nickel, Ytterbium and Silicon. The method comprises providing a layer stack (14, 13) comprising Nickel, Ytterbium and Silicon and annealing said layer stack (14, 13) to form a Nickel, Ytterbium, Silicon alloy.

The present invention discloses a nMOSFET comprising a gate electrode (5) and a gate dielectric (4) characterized in that the gate electrode (5) comprises Nickel (Ni), Ytterbium (Yb) and Silicon (Si).

The present invention also discloses a method to manufacture a fully silicided nMOSFET (FUSI nMOSFET), comprising, providing a nMOSFET comprising a semiconductor gate electrode (13), forming a layer stack (14) comprising Nickel and Ytterbium at least on said semiconductor gate electrode (13) and transforming said semiconductor gate electrode (13) in a Nickel Ytterbium Silicide gate electrode (5).

The method can further comprise forming a capping layer (15) over said layer stack (14) before forming the Nickel Ytterbium Silicide gate electrode (5).

The method can further comprise selectively removing the unreacted Nickel and Ytterbium after forming the Nickel Ytterbium Silicide gate electrode (5).

In relation to the drawings, the present invention is described in detail in the sequel. It is apparent however that a person skilled in the art can imagine several other equivalent embodiments or other ways of executing the present invention.

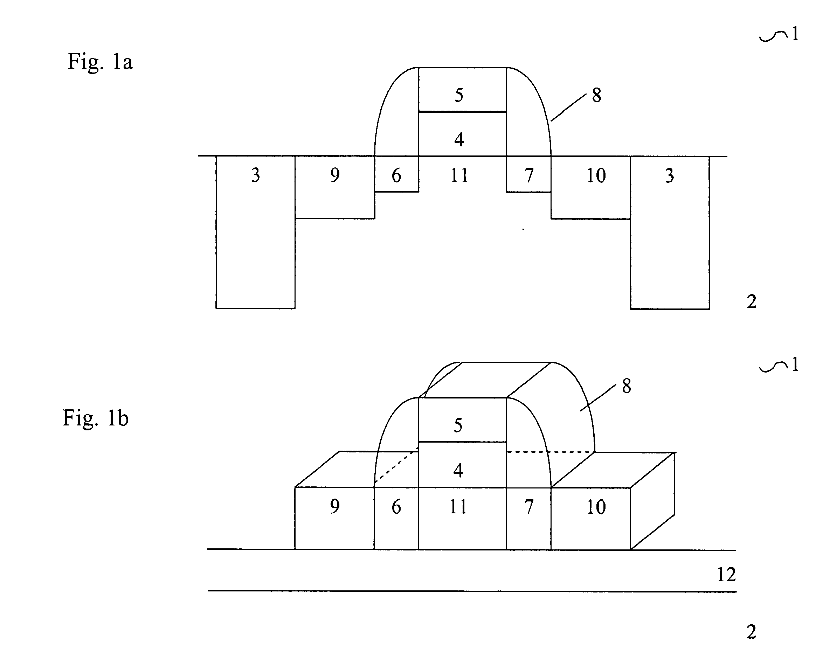

Figures 1a and 1b show a schematic cross-sectional view of n-type Metal-Oxide-Semiconductor Field Effect Transistors (nMOSFET) according to the invention.

A nMOS device of the invention comprises a gate stack formed on a semiconducting layer (2). The gate stack comprises a gate dielectric (4) in contact with this semiconducting layer (2) and a gate electrode (5) in contact with this gate dielectric (4).

The gate dielectric can be a silicon-oxide, a silicon-oxy-nitride (SiₓO_{y}N_{1-x-y}), an high-k dielectric (i.e. k>3,9) such as Hafnium or Aluminum silicates or oxides, e.g. HfO₂, Al₂O₃.

The gate electrode (5) comprises a low work function metallic alloy. This low work function metallic alloy comprises Nickel, Ytterbium and silicon.

An alloy of the invention can be represented by the formula NiₓYb_{y}Si_{1-x-y}, where x and y are real numbers, and can range respectively from 0,3 to 0,7 and from 0,005 to 0,2 (i.e. 0.3<x<0.7, and 0.005<y< 0.2). Preferably x = 0.55 and y = 0.12.

The nMOS device can further comprise spacers (8) formed adjacent the gate stack (4, 5) and junction regions (6, 7, 9, 10).

The present invention can be applied to various device architectures. Figure 1a shows an example of a nMOSFET device formed on a bulk substrate 2 while figure 1b shows a MugFET nMOS, i.e. a Multiple gate FET such as a FinFET, formed upon the dielectric (12) of a SOI substrate.

FinFet devices are known in the art as discussed in European Patent Application EP 1383166.

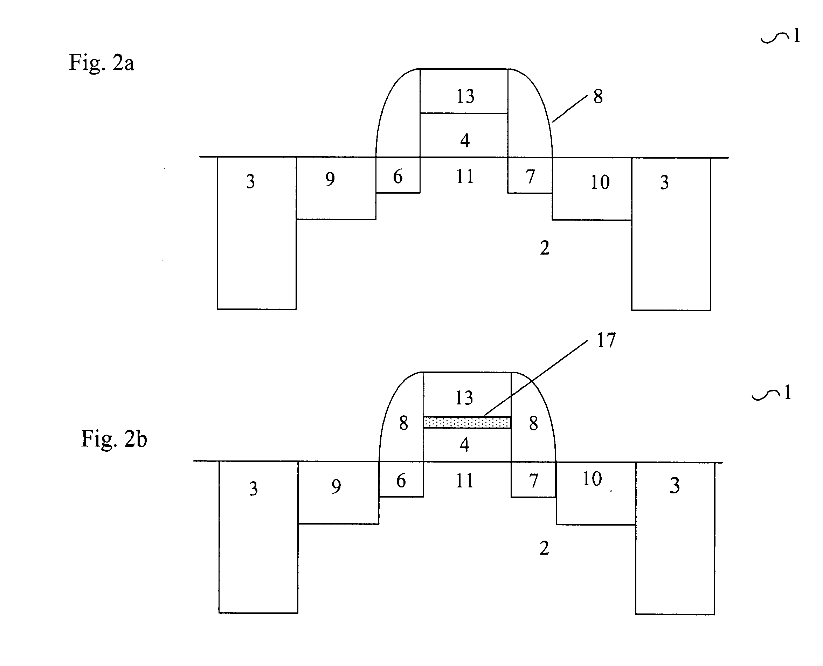

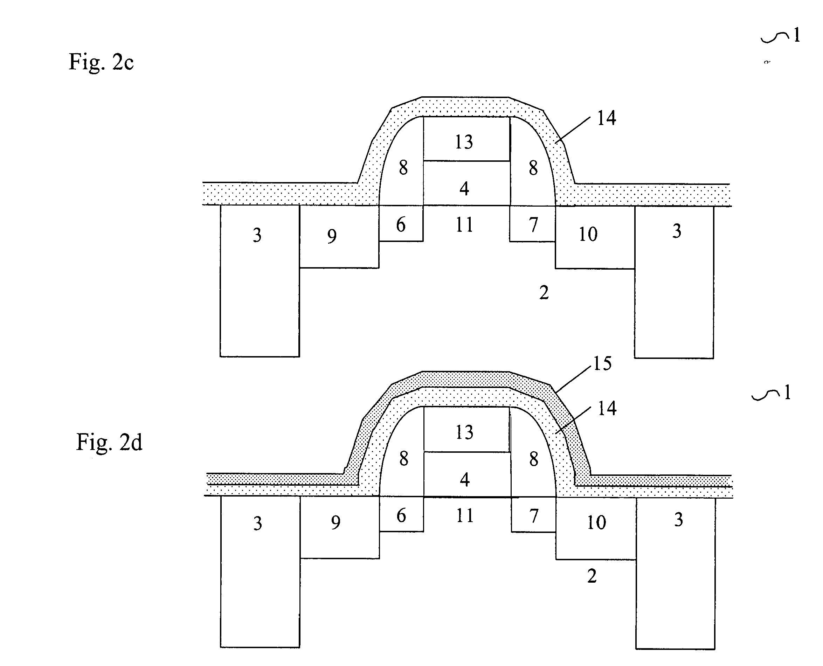

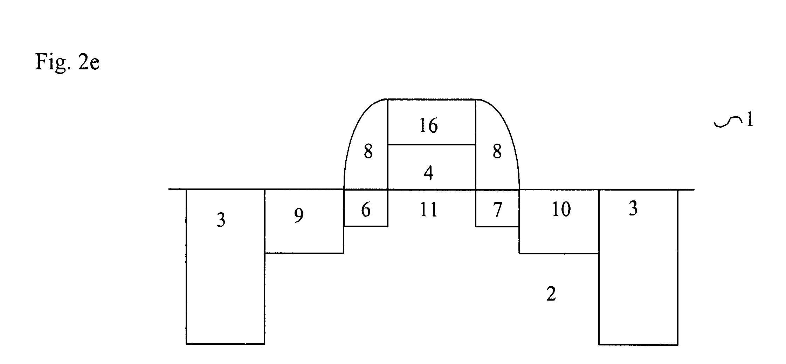

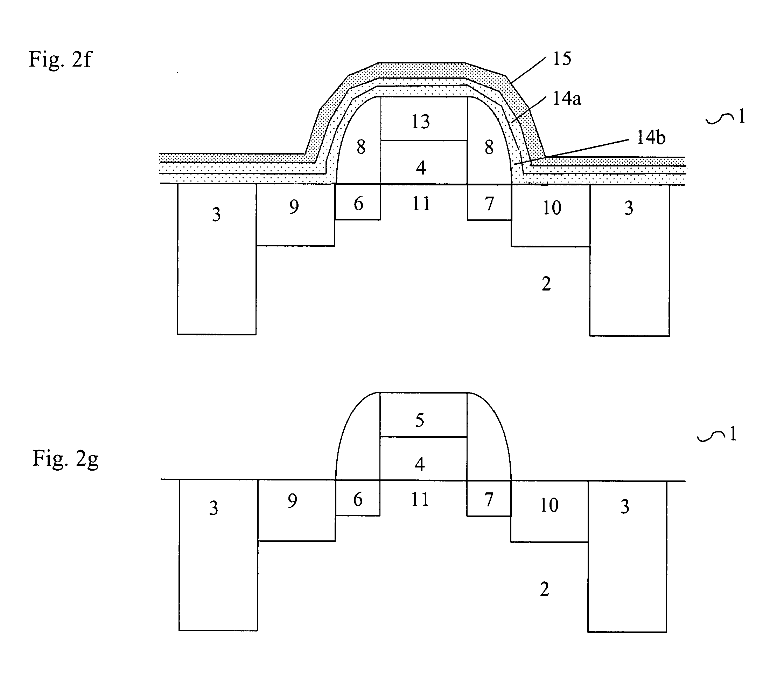

Figure 2 illustrates by means of schematic cross-sections a process for manufacturing devices according to the present invention. For the purpose of illustrating this process a bulk nMOSFET is used (represented) although the invention is not intended to be limited thereto.

Figure 2a shows a cross-section of the nMOSFET after the spacers (8) after formed. A method of the invention can comprise the steps of forming a gate stack (4, 13), and spacers (8) adjacent this gate stack.

Spacers can be formed from silicon-oxide, silicon-oxy-nitride (SiₓO_{y}N_{1-x-y}), silicon nitride, silicon carbide or from a combination of these materials.

At opposite sides of this gate stack n-type source/drain junction regions are formed, typically as a combination of extension regions (6,7) underneath the spacers (8) and connection regions (9, 10) adjacent these extension regions and aligned to the spacers (8).

Dielectrically coupled to the gate stack, a channel region (11) is present in the semiconductor layer, which in this case is the semiconductor substrate itself (2).

The active area region (not indicated) in which the transistor (1) is formed, is separated from other active area regions by so-called field regions (3) formed by known techniques such as Local Oxidation of Silicon (LOCOS) or Shallow Trench Insulation (STI).

The gate dielectric (4) can be a silicon-oxide, a silicon-oxy-nitride (SiₓO_{y}N_{1-x-y}), an high-k dielectric such as Hafnium or Aluminum silicates or oxides, e.g. HfO₂, Al₂O₃.

The gate electrode (13) is formed in a semiconductor material. This semiconductor material is preferably silicon. This silicon can be in a monocrystalline, polycrystalline or amorphous state. The thickness of the gate electrode (13), i.e. the amount of semiconductor material available, can be determined in view of the desired composition of the later-formed silicide as will be shown later.

As shown in figure 2b a diffusion barrier layer (17) can be present in between the gate electrode (13) and the gate dielectric (4). This diffusion barrier (17) will prevent diffusion of the Ytterbium into the gate dielectric (4) during the silicidation process. An example of such diffusion barrier (17) is silicon-nitride.

A layer or stack of layers (14) comprising Nickel and Ytterbium is deposited over the device as illustrated in figure 2c.

The layer stack (14) can be in the form of single layer comprising an alloy of Nickel and Ytterbium having the desired composition, i.e. the ratio Nickel/Ytterbium, and the desired total amount of Nickel and Ytterbium, i.e. layer thickness. This single layer can be obtained for example by simultaneously sputtering Nickel and Ytterbium from their respective targets on the substrate at predetermined deposition rates or by sputtering an alloy of Nickel Ytterbium having the desired composition on the substrate.

The layer stack (14) can be in the form of a stack of layers e.g. by sequentially sputtering layers of respectively Nickel and Ytterbium whereby the thickness of the individual layers determines the amount of Nickel and Ytterbium available and the ratio of the layer thickness determines the ratio of Nickel/Ytterbium.

Optionally a capping layer (15) is deposited on the layer stack (14) as shown in figure 2d. This capping layer prevents oxidation of the Ytterbium during the subsequent silicide forming annealing process. The material of this capping layer must have oxygen diffusion barrier properties and be substantially oxide .free. Preferably this capping layer comprises HfN.

The layer stack (14) can be formed by sequentially sputtering layers of Ytterbium and Nickel, e.g. first depositing Ytterbium and covering the deposited Ytterbium layer with Nickel, whereby the top Nickel layer can act as an oxygen diffusion barrier (15) and no additional capping layer is needed.

Alternatively, Nickel and Ytterbium can be co-deposited or an alloy of Nickel and Ytterbium can be sputtered, and a Nickel layer can be used as capping layer thereby avoiding the need for a separate capping layer (15) and corresponding etching steps to remove such additional capping layer.

After depositing the Nickel and Ytterbium in the desired amounts and ratio upon the substrate the silicidation process is performed. Nickel, Ytterbium from the layer stack (14) and silicon from the gate electrode (13) react with each other to form a metallic Nickel-Ytterbium silicide. During the annealing process the semiconductor gate electrode (13) is transformed in a metallic Nickel Ytterbium Silicon gate electrode (5).

The composition of this alloy depends on the relative amounts available of Nickel, Ytterbium and silicon.

The conditions of this silicidation process, e.g. time, temperature of this annealing process, are chosen such that substantially the complete silicon gate electrode (13) is converted into a metallic gate electrode (5) resulting in a so-called Fully Silicided gate electrode (FUSI). Preferably, the silicide forming temperature is within the range of 350°C to 600°C, more preferably at about 400°C while the duration of the silicide forming process is within the range of 30s to 90s, preferably about 60s.

After fully siliciding the silicon gate electrode (13), the unreacted metals, i.e. Nickel, Ytterbium, are removed selectively to underlying layers such as the silicide (16), the spacers (8) and the field regions (3).

Preferably the Nickel is removed selectively by a wet etch of about 5 minutes using an etchant comprising HNO₃.

If a capping layer (15) (different from Ni) is present, first this capping layer is selectively removed before removing the unreacted metals.

If HfN is used to form the capping layer, preferably a wet etch using an etchant such as diluted HF is used to selectively remove the HfN capping layer.

Figure 2e shows the device comprising the FUSI gate electrode (5) after selectively removing the unreacted Nickel, Ytterbium and the capping layer if present.

According to a preferred embodiment, on p-type silicon substrates (2) MOS capacitors are fabricated by first depositing a SiON dielectric layer (4) thereon.

On top said dielectric layer (4) undoped polysilicon (13) is deposited, preferably using Chemical Vapor Deposition (CVD).

On top of said polysilicon layer a layer stack (14) of Ytterbium (Yb) (14a) and Nickel (Ni) (14b) are deposited, preferably by Plasma Vapor Depositing (VPD) in an Argon ambient.

Both Ni and Yb can be co-sputtered and then the deposition of Yb can be stopped while the deposition of Ni is continued.

On top of the Ni-Yb layer stack, a Hafnium Nitride (HfN) layer (15) is deposited. This HfN layer (15) is used as capping layer to avoid oxidation of Yb during the subsequent annealing step needed to have the Ni-Yb react with the underlying polysilicon thereby forming a Nickel Ytterbium Silicide.

The silicide forming process is preferably performed in vacuum (10e-5 torr, i.e. 1,33.10e-5 mbar) at about 400°C for about 1 minute.

After the fully silicidation of the gate, the HfN capping layer is selectively removed, preferably by a wet etch, e.g. of about 5 minutes, e.g. using diluted HF solution.

Then the remaining unreacted metal, Ni and/or Yb, is selectively removed, preferably by a wet etch, e.g. of about 5 minutes, e.g. using dilute HNO₃.

As a result of this processing MOS capacitors are obtained having a FUSI Nickel-Ytterbium-Silicide gate electrode (5) on top of a SiON gate dielectric (4) formed on p-type substrates (2), as depicted in figure 2g.

Preferably, in said Nickel-Ytterbium-Silicide represented by the formula NiₓYb_{y}Si_{1-x-y}, x is equal to 0.55, and y is equal to 0.12.

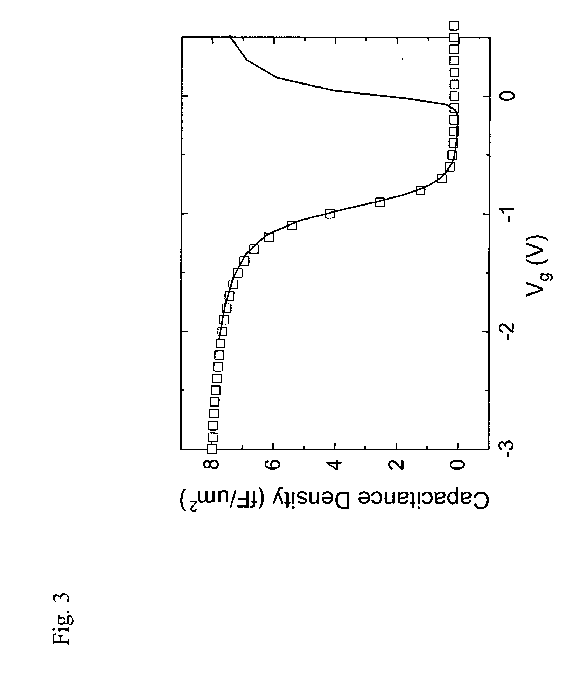

Figure 3 shows the measured and simulated C (fF/µm²)-V_{g} (V) data for a 100 by 100 µm² capacitor processed as described in the example section. The flat-band voltage V_{fb} is extracted to be about -0.8V. The complete silicidation of the polysicilicon layer (13) is confirmed by comparing the extracted Equivalent Oxide Thickness (EOT) value of 3.75nm with the physical thickness of the dielectrics determined by ellipsometry. From this comparison one can conclude that no depletion effect occurs at the gate electrode side and that gate capacitance measured during the positive bias of the gate electrode (5) with respect to substrate (2) corresponds the capacitance of the gate dielectric. The good matching between the measured data (open squares) and the fitted data (solid line) shows that essentially no interface states Dᵢₜ are present in between the FUSI gate electrode and the SiON gate dielectric.

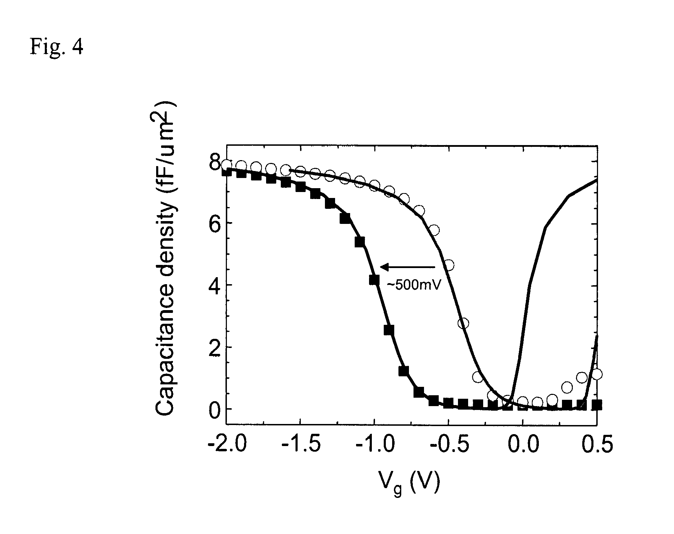

Figure 4 compares the measured and simulated (solid line) C (fF/µm²)-V_{g} (V) data for a 100 by 100 µm² capacitor having a Nickel-Ytterbium-Silicon FUSI gate (solid squares) with the measured and simulated C (fF/µm²)-Vg (V) data for a similar, 100 by 100 µm², capacitor but having a prior art Nickel-Silicide (NiSi) FUSI gate (open circles). Due to the presence of the Nickel-Ytterbium-Silicon FUSI gate the C-V_{g} curve is shifted about 500mV towards more negative gate voltages. This voltage shifts illustrates that the low work function metal according to the present invention exhibits n-type electronic properties and that it is suitable as electrode material for nMOS devices.

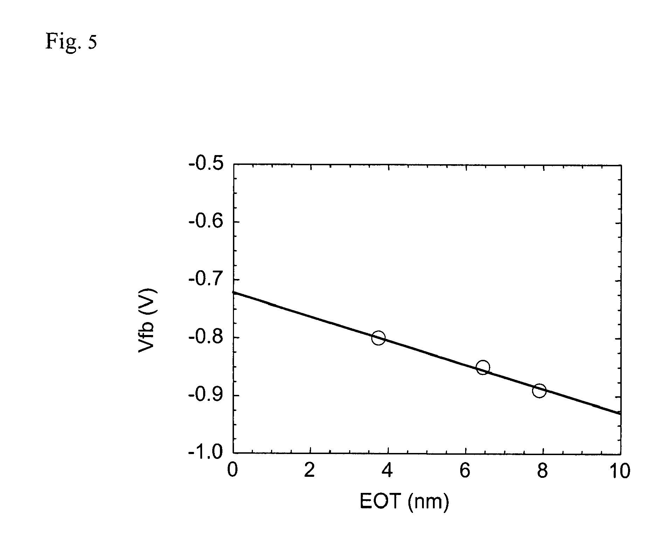

From the relationship between the experimentally obtained (circles) Equivalent Oxide Thickness (EOT) and the flat-band voltage (V_{fb}) shown in figure 5, the work function value of Nickel Ytterbium Silicon FUSI on SiON dielectric is extracted by a linear fit (solid line) as 4.22eV. The work function of Nickel-Ytterbium-Silicon on SiON is about 4.22eV, which makes this material suitable to be used as the gate electrode for n-MOSFETs.

In another embodiment capacitor structures were processed which are similar to the capacitor structures disclosed in the example section. However the composition of the Nickel Ytterbium Silicon FUSI gate was varied and several approaches to form the as-deposited Nickel Ytterbium metal stack (14) were used.

On various capacitor structures Nickel-Ytterbium metal stacks were deposited having substantially the same as-deposited stack thickness of about 80nm but with different Nickel/Ytterbium thickness ratio.

As was done in the example section, the thickness of the Nickel and of the Ytterbium layer is controlled by the rate and time at which Nickel, respectively, Ytterbium are co-sputtered.

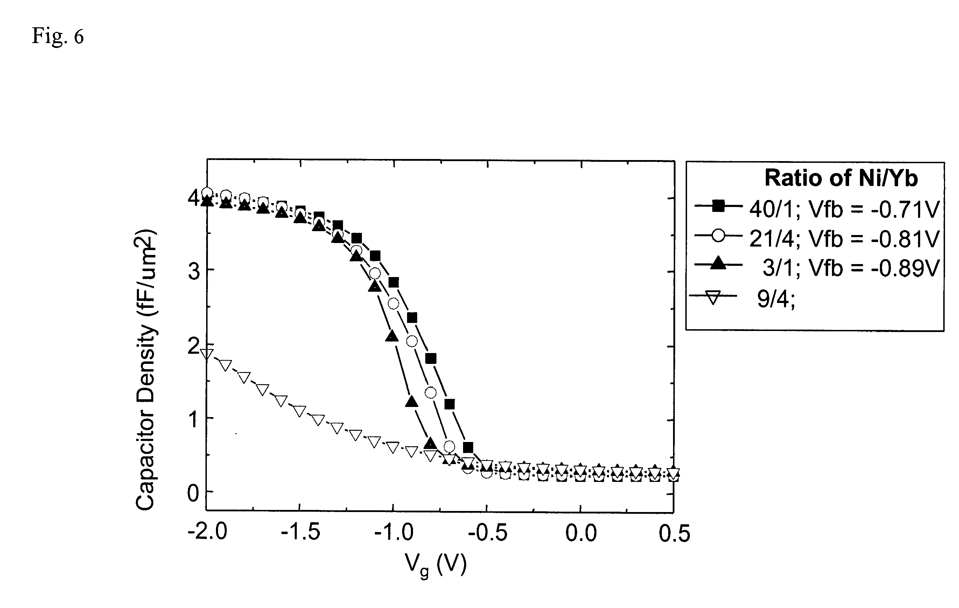

Figure 6 shows the effect of the Nickel Ytterbium Silicon composition on the C-V characteristics of these structures.

The equivalent oxide thickness of these capacitor structures is determined as being about 7.9nm.

Compared to the C-V curve of a NickelSilicon FUSI gate shown in figure 4 (open circles) the C-V curve is shifted to negative gate voltages from a Ni/Yb thickness ratio as low as 40/1 having a flat-band voltage V_{fb} of - 0.71V (solid squares).

Increasing the relative amount of Ytterbium in the metal stack shifts the flat-band voltage to even more negative gate voltages: Ni/Yb = 21/4 (open circles) with V_{fb} of -0.81V, Ni/Yb = 3/1 (upward diamond) with V_{fb} of -0.89V.

However if too much Ytterbium is incorporated no meaningful flat-band voltage could be extracted from the corresponding C-V curve.

On various capacitor structures Nickel Ytterbium metal stacks were deposited having substantially the same as-deposited stack thickness of about 80nm and substantially the same Nickel/Ytterbium thickness ratio of 4/1.

The Nickel Ytterbium metal stack (14) was formed either by simultaneous depositing the Nickel and Ytterbium as was done in the example section or by sequentially depositing both metals, e.g. first depositing the Ytterbium layer and afterwards forming the Nickel layer.

The equivalent oxide thickness of these capacitor structures is determined as being about 7.9nm.

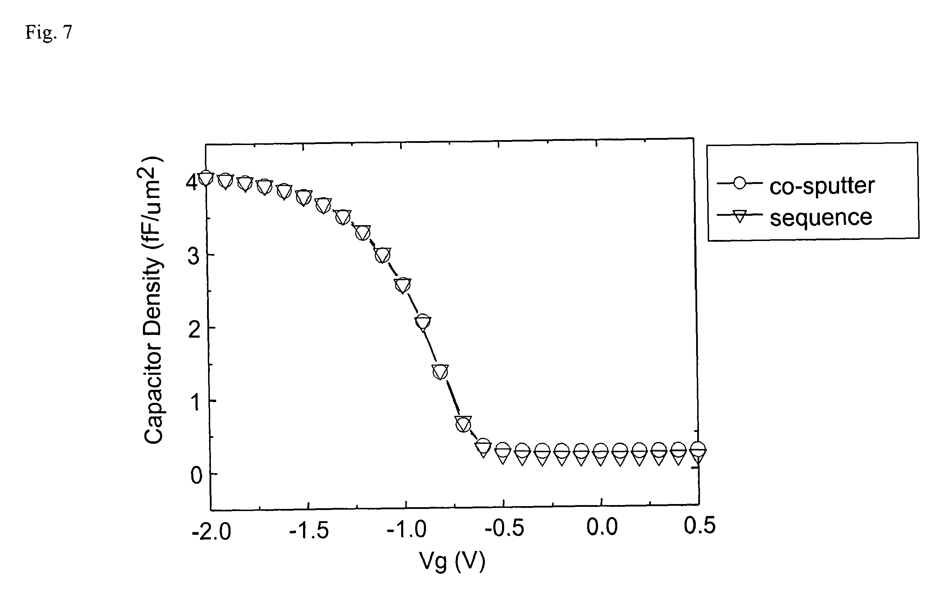

Figure 7 shows the effect of the deposition method on the C-V characteristics of these structures.

If Nickel and Ytterbium are co-sputtered (open circles) a flat-band voltage of about -0.81V is obtained.

If Nickel and Ytterbium are deposited in a sequential way (open diamonds) the corresponding C-V curve coincides with the C-V curve obtained for the co-sputtered metal stack (open circles) and a flat-band voltage of about -0.81V is obtained.

From figure 6 and 7 it is clear that the electric properties of a Nickel-Ytterbium-Silicon FUSI gate are in first instance function of the relative amounts of Nickel and Ytterbium present in the as-deposited metal stack.

This metal stack can be formed using various ways without substantially affecting the electronic properties of the resulting FUSI gate.

The present invention hence discloses a low work function metal comprising Nickel, Ytterbium and Silicon.

This low work function metal can be used as n-type gate electrode material, for example to form the gate electrode of a nMOSFET.

The present invention allows the formation of electronic circuits comprising nMOSFETs and pMOSFETs, wherein the gate electrode of the nMOSFETs is formed according to the present invention.

### EXAMPLE

In a preferred embodiment of the invention as depicted in figure 2f, the formation of a NiYb silicide is disclosed. On p-type silicon substrates (2) MOS capacitors were fabricated by first depositing a SiON dielectric layer (4) thereon. SiON layers with various thicknesses have been formed on various wafers. On top of each dielectric layer (4) undoped polysilicon (13) is deposited using Chemical Vapor Deposition (CVD). The polysilicon layer (13) had a thickness of about 100nm. On top of each polysilicon layer a layer stack (14) of Ytterbium (Yb) (14a) and Nickel (Ni) (14b) was deposited by Plasma Vapor Depositing (VPD) in an Argon ambient. Yb was deposited at a rate of about 10nm/min, and Ni at a rate of about 17nm/min. Firstly both Ni and Yb were co-sputtered for 1.5 min. Then the deposition of Yb was stopped while the deposition of Ni was continued for another 2.5 min. In total about 68 nm of Ni and about 15nm of Yb was deposited resulting in a total metal layer thickness of about 80nm. On top of the Ni-Yb layer stack (14) a Hafnium Nitride (HfN) layer (15) of about 50nm was deposited. This HfN layer (15) is used as capping layer to avoid oxidation of Yb during the subsequent annealing step needed to have the Ni-Yb react with the underlying polysilicon thereby forming a Nickel Ytterbium Silicide. The silicide forming process was performed in vacuum (10e-5 torr, i.e. 1,33.10e-5 mbar) at about 400°C for about 1min. After the fully silicidation of the gate the HfN capping layer was selectively removed by a wet etch of about 5 minutes using diluted HF solution. Then the remaining unreacted metal, Ni and/or Yb, was selectively removed by a wet etch of about 5 minutes using dilute HNO₃. As a result of this processing MOS capacitors are obtained having a FUSI Nickel-Ytterbium-Silicon gate electrode (5) on top of a SiON gate dielectric (4) formed on p-type substrates (2), as depicted in figure 2g.
The resulting Nickel-Ytterbium-Silicon gate electrode layer had a thickness of about 110 to 120nm with a smooth interface with the underlying SiON gate dielectric. The average sheet resistance Rₛ of this gate electrode layer (5) was about 5.5 ohm/square which is comparable to the sheet resistance of a NickelSilicon gate electrode layer. Using Auger - Electron-Spectroscopy (AES) the stoichiometric composition of this layer was determined as NiₓYb_{y}Si_{1-x-y} with x = 0.55, y = 0.12 and 1-x-y = 0.33.

## Claims

1. A nMOSFET comprising a gate electrode (5) and a gate dielectric (4) **characterized in that** the gate electrode (5) comprises Nickel (Ni), Ytterbium (Yb) and Silicon (Si).

2. A nMOSFET according to claim 1 wherein the gate electrode consists of an alloy of Nickel (Ni), Ytterbium (Yb) and Silicon (Si).

3. A nMOSFET according to claim 2 wherein said alloy is represented by the formula NiₓYb_{y}Si_{1-x-y} where 0.3 < x < 0.7, and 0.005 < y < 0.2.

4. The nMOSFET according to claim 3 wherein x = 0.55 and y = 0.12.

5. A metallic alloy comprising Nickel (Ni), Ytterbium (Yb) and Silicon (Si).

6. A metallic alloy according to claim 5 represented by the formula NiₓYb_{y}Si_{1-x-y} where 0.3 < x < 0.7, and 0.005 < y < 0.2.

7. Use of a metallic alloy according to claim 5 or 6 as a low work function material.

8. A method for forming a nMOSFET comprising the steps of:
- depositing Nickel and Ytterbium on at least a semiconductor gate electrode comprising silicon (13),
- transforming said semiconductor gate electrode (13) in a Nickel-Ytterbium-Silicide gate electrode (5).

9. A method according to claim 8, wherein the step of depositing said Nickel and Ytterbium consist of depositing alternatively at least one layer of nickel and at least one layer of ytterbium.

10. A method according to claim 9, wherein the last layer deposited is a nickel layer.

11. A method according to any of claims 8 to 10, wherein said Nickel and Ytterbium are sequentially sputtered on said semiconductor gate electrode (13).

12. A method according to claim 8, wherein said Nickel and Ytterbium are co-deposited, in particular are simultaneously sputtered on said semiconductor gate electrode (13).

13. A method according to any of claims 8 to 12 further comprising the step of forming a capping layer (15) over said deposited Nickel and Ytterbium (14) before the step of transforming said semiconductor gate electrode (13) in a Nickel-Ytterbium-Silicide gate electrode (5).

14. A method according to any of claims 8 to 13 further comprising the step of selectively removing the unreacted Nickel and Ytterbium after forming the Nickel-Ytterbium Silicide gate electrode (5).

15. A method for forming a low work function alloy comprising the steps of:
- providing at least one layer comprising Nickel, Ytterbium and Silicon, or
- providing at least one layer stack comprising Nickel, Ytterbium and Silicon, wherein each layer comprises Nickel, Ytterbium and/or Silicon, and
- annealing said layer(s) to form a Nickel, Ytterbium, Silicon alloy.
